# EUROPÄISCHE PATENTANMELDUNG

(11) **EP 2 938 170 A1**
(43) Veröffentlichungstag der Anmeldung: **28.10.2015**
(21) Anmeldenummer: 14165642.1
(22) Anmeldetag: 23.04.2014
(51) Int. Cl.: H05K 1/18

(54) **Halter für SMD-Leuchtdiode**

(71) Anmelder: odelo GmbH, 70329 Stuttgart (DE)
(72) Erfinder: Die Erfindernennung liegt noch nicht vor
(74) Vertreter: Benninger, Johannes

(57) **Zusammenfassung**

Es wird ein Halter (01) zur elektrischen Kontaktierung und mechanischen Befestigung mindestens einer SMD-Leuchtdiode (02) beschrieben. Der Halter weist wenigstens zwei unter einem Winkel zueinander angeordneten Montageflächen (03, 04, 05) auf, zumindest eine erste Montagefläche für die mindestens eine SMD-Leuchtdiode (02) und zumindest eine zweite Montagefläche (04, 05) zur Montage des Halters (01) auf einem Leuchtmittelträger. Die mindestens eine erste Montagefläche (03) weist in einer durch die jeweilige erste Montagefläche (03) gebildeten Ebene liegende elektrische Anschlüsse (31, 32, 33) auf, welche bei der Montage einer SMD-Leuchtdiode (02) auf der ersten Montagefläche die SMD-Leuchtdiode (02) elektrisch kontaktieren. Die mindestens eine zweite Montagefläche (04, 05) weist ebenfalls elektrische Anschlüsse (41, 42, 43, 51, 52, 53) auf, welche bei der Montage des Halters (01) auf einem Leuchtmittelträger elektrische Leiterbahnen des Leuchtmittelträgers elektrisch kontaktieren. Die elektrischen Anschlüsse (31, 32, 33, 41, 42, 43, 51, 52, 53) der ersten und der zweiten Montageflächen (04, 05) des Halters (01) sind derart elektrisch miteinander verbunden, dass an den elektrischen Anschlüssen (31, 32, 33) der mindestens einen ersten Montagefläche (03) eine elektrische Spannung anliegt, wenn an den elektrischen Anschlüssen (41, 42, 43, 51, 52, 53) der mindestens einen zweiten Montagefläche (04, 05) eine elektrische Spannung angelegt ist.

## Beschreibung

Die Erfindung betrifft einen Halter gemäß dem Oberbegriff des Anspruchs 1.

Als Lichtquellen von Leuchtmitteln kommen unter anderem wegen ihres hohen Wirkungsgrads bei der Umwandlung elektrischen Stroms in Licht und ihres damit einhergehend geringen Stromverbrauchs vermehrt Leuchtdioden zum Einsatz.

Herausragende Eigenschaften von Leuchtdioden im Vergleich zu anderen, herkömmlichen Lichtquellen von Leuchtmitteln, wie etwa Glüh- oder Gasentladungslampen, sind eine wesentlich längere Lebensdauer und eine wesentlich höhere Lichtausbeute bei gleicher Leistungsaufnahme. Dadurch und unter anderem auch wegen ihrer kompakteren Abmessungen können durch Verwendung von Leuchtdioden als Lichtquellen Leuchtmittel und damit Leuchten verwirklicht werden, die an fast jede nur erdenkliche Anwendung angepasst sein können.

In einem Leuchtmittel können dabei eine oder mehrere, einzeln oder gruppenweise, beispielsweise in einem Strang zu mehreren angeordnete Leuchtdioden als mindestens eine Lichtquelle vorgesehen sein.

Ein mit einer oder mehreren, einzeln oder gruppenweise angeordneten Leuchtdioden als mindestens eine Lichtquelle ausgestattetes Leuchtmittel umfasst wenigstens einen Leuchtmittelträger mit Leiterbahnen zur elektrischen Kontaktierung der Leuchtdioden, beispielsweise in Form einer oder mehrerer ebener Platinen mit aufgedruckten oder geätzten Leiterbahnen, so genannter Printed Circuit Boards, kurz PCB, oder in Form eines oder mehrerer als Kunststoffspritzteil in Molded Interconnect Devices (MID) Technik hergestellter, spritzgegossener Schaltungsträger mit in das Kunststoffspritzteil integrierten Leiterbahnen und integrierter mechanischer und elektrischer bzw. elektronischer Funktion. Auf einem oder mehreren solchen spritzgegossenen Schaltungsträgern mit komplexen Formen können eine oder mehrere Leuchtdioden unter gleichzeitiger mechanischer Befestigung und elektrischer Kontaktierung angeordnet sein. Ebene Platinen bzw. PCBs benötigen selbst einer mechanischen Befestigung beispielsweise in einer Leuchte, wohingegen spritzgegossene Schaltungsträger in MID-Technik selbst Funktionen beispielsweise eines Leuchtengehäuses und/oder eines Reflektors übernehmen und ausführen können, um nur einige Beispiele zu nennen.

Darüber hinaus kann das Leuchtmittel ein oder mehrere Elektronikbauelemente umfassen.

Zum Betrieb von Leuchtdioden als Lichtquellen für ein Leuchtmittel können eine oder mehrere mehr oder minder komplexe elektronische Steuerschaltungen vorgesehen sein, die beispielsweise auf einem oder mehreren Leuchtmittelträgern des Leuchtmittels angeordnet, dort mechanisch befestigt und elektrisch kontaktiert sein können.

Ein einfaches Beispiel für eine elektronische Steuerschaltung betrifft die Angleichung unterschiedlicher Helligkeiten einzelner Leuchtdioden oder von Leuchtdioden-Strängen innerhalb einer Gruppe gemeinsam betriebener, auf einem oder mehreren Leuchtmittelträgern angeordneter Leuchtdioden. Eine solche elektronische Steuerschaltung besteht aus mindestens einem oder mehreren Vorwiderständen zur Anpassung der Vorwärtsspannung der Leuchtdioden an die Stromversorgung. Beispielsweise ist bekannt, die Leuchtdioden im so genannten Binning nach Vorwärtsspannung und Intensität zu sortieren. Um Unterschiede zwischen mehreren Leuchtdioden-Strängen auszugleichen, die jeweils aus in Reihe geschalteten Leuchtdioden gleicher Vorwärtsspannung und Intensität bestehen, und um eine homogene Helligkeitsverteilung der benachbarten Leuchtdioden-Stränge aus Leuchtdioden mit unterschiedlicher Vorwärtsspannung und Intensität zu erhalten, wird zumindest jeder Leuchtdioden-Strang mit einem anderen Vorwiderstand versehen.

Leuchtdioden bedürfen darüber hinaus beim Einsatz als Lichtquelle insbesondere in Kraftfahrzeugleuchten oft einer separaten Ausfallerkennung. Dies ist bedingt durch die geringe Leistungsaufnahme von Leuchtdioden im Allgemeinen. Beispielsweise ist ein in einem Kraftfahrzeug untergebrachtes Steuergerät nicht in der Lage, eine dem Ausfall einer oder weniger Leuchtdioden entsprechende Änderung der Leistungsentnahme aus dem die Stromversorgung bildenden Bordnetz zu erkennen, da eine hieraus resultierende Bordnetzspannungsänderung unterhalb der im normalen Betrieb eines Kraftfahrzeugs auftretenden Bordnetzspannungssschwankung liegt. Eine beispielsweise in der Kraftfahrzeugleuchte untergebrachte elektronische Schaltungsanordnung zur Ausfallerkennung erfasst den Ausfall einer oder mehrerer Leuchtdioden in der Kraftfahrzeugleuchte z.B. mittels eines oder mehrerer Komparatoren und teilt dies dem Steuergerät mit. Diese elektronische Schaltungsanordnung zur Ausfallerkennung kann durch eine beispielsweise auf dem Leuchtmittelträger aufgebrachte elektronische Steuerschaltung verwirklicht sein.

Darüber hinaus können Leuchtdioden weiterer elektronischer Steuerschaltungen bedürfen. Beispiele hierfür sind elektronische Steuerschaltungen:
- zur Regelung und/oder Steuerung der Helligkeit bzw. Leuchtkraft der Leuchtdioden, beispielsweise durch eine pulsweitenmodulierte Taktung der Stromversorgung für einen außerhalb des für das menschliche Auge wahrnehmbaren Bereichs gepulsten Betrieb,
- zur Kompensation oder Vermeidung elektromagnetischer Störungen, beispielsweise aufgebaut aus Kondensatoren und/oder Ferriten,
- zum Schutz der Leuchtdioden z.B. vor einer Überspannung der Stromversorgung oder vor fehlerhafter Polung, beispielsweise umfassend eine oder mehrere Zenerdioden.

Zusammengefasst muss für fast alle Leuchtdioden-Anwendungen eine mehr oder minder umfangreiche, für die speziellen Leuchtdioden ausgelegte elektronische Steuerschaltung z.B. auf den mindestens einen Leuchtmittelträger aufgebracht werden. Die elektronische Steuerschaltung umfasst im einfachsten Fall einen Vorwiderstand und eine Schutzdiode, kann aber je nach Anwendung auch wesentlich mehr Elektronikbauteile enthalten, wie z.B. Mikrokontroller bzw. Kontroller, Komparatoren, Transistoren, Schutzdioden, elektrische Widerstände z.B. als Vorwiderstand, Kondensatoren, Ferrite, etc.

Somit kann ein Leuchtmittel mit einer oder mehreren Leuchtdioden als Lichtquelle zumindest ein oben genanntes Elektronikbauteil sowie mindestens eine Leuchtdiode umfassen. Demnach kann ein Leuchtmittel mit einer oder mehreren Leuchtdioden als Lichtquellen neben der mindestens einen Leuchtdiode zumindest noch über ein weiteres Elektronikbauelement verfügen.

Eine zur Verwendung als Lichtquelle eines Leuchtmittels vorgesehene, zur Montage auf einem Leuchtmittelträger ausgebildete Leuchtdiode besteht zumindest aus wenigstens einem Lichtemittierende-Diode-Halbleiter-Chip, kurz LED-Chip, sowie aus mindestens einem Kontaktmittel zur elektrischen Kontaktierung des LED-Chips. Üblicherweise verfügt jede Leuchtdiode über einen Bonddraht je LED-Chip, welcher je einen LED-Chip elektrisch kontaktiert. Dieser Bonddraht bildet wenigstens ein Kontaktmittel der Leuchtdiode. Der Bonddraht kann mit einem elektrischen Anschluss verbunden sein, welcher zur elektrischen Kontaktierung der Leuchtdiode mit einer Leiterbahn des Leuchtmittelträgers vorgesehen ist. Der LED-Chip ist darüber hinaus selbst zur elektrischen Kontaktierung mit einer zweiten Leiterbahn des Leuchtmittelträgers vorgesehen, beispielsweise über einen mit dem LED-Chip verbundenen zweiten elektrischen Anschluss. Auch kann der LED-Chip selbst einen elektrischen Anschluss der Leuchtdiode bilden, wie nachfolgend zu den verschiedenen Kontaktierungsmöglichkeiten von Leuchtdioden noch ausgeführt.

Die Leuchtdiode kann darüber hinaus einen den LED-Chip unmittelbar umgebenden Primärreflektor aufweisen. Dieser Primärreflektor kann beispielsweise durch Wandungen einer den LED-Chip umgebenden Ausnehmung und/oder durch einen Napf gebildet sein, in dem der LED-Chip angeordnet ist. Der Napf kann mit dem erwähnten zweiten Anschluss verbunden sein, diesen bilden oder umfassen oder von diesem umfasst werden. Der zweite Anschluss bildet ebenfalls ein Kontaktmittel der Leuchtdiode. Der zweite Anschluss kann jedoch auch durch den LED-Chip selbst gebildet sein, indem der LED-Chip selbst unmittelbar auf einer ersten Leiterbahn des Leuchtmittelträgers platziert wird. In diesem Fall bilden der auf einer ersten Leiterbahn des Leuchtmittelträgers platzierte LED-Chip und der mit einer zweiten Leiterbahn verbundene Bonddraht die Kontaktmittel und gleichzeitig die elektrischen Anschlüsse der Leuchtdiode.

Bekannt sind Leuchtdioden zur Durchsteckmontage (THT; Through Hole Technology), oberflächenmontierbare (SMD; Surface Mounted Device) Leuchtdioden und Leuchtdioden, bei denen der LED-Chip in Nacktmontagetechnik (COB; Chip On Board) direkt auf den Leuchtmittelträger gebondet wird.

THT-Leuchtdioden sind der gängig bekannte Typ Leuchtdioden. Sie werden auch als bedrahtete Leuchtdioden bezeichnet, da sie aus einer zumindest in einer gewünschten Abstrahlrichtung transparenten Kapselung, z.B. in Form einer Umspritzung oder eines Vergusses bestehen, welche den mit einem ersten elektrischen Anschluss, beispielsweise in Form eines Kathodenanschlusses, verbundenen LED-Chip und einen den LED-Chip mit einem zweiten elektrischen Anschluss, beispielsweise in Form eines Anodenanschlusses verbindenden Bonddraht einschließt. Aus der Kapselung ragen nur die auch als Beinchen bezeichneten Drähte des ersten elektrischen Anschlusses und des zweiten elektrischen Anschlusses als die Anoden- und Kathodenanschlüsse der THT-Leuchtdiode. Der beispielsweise als Kathodenanschluss ausgeführte erste elektrische Anschluss kann hierbei mit einem oben erwähnten Napf versehen sein, in dem der LED-Chip angeordnet ist. Der Bonddraht führt vom beispielsweise als Anodenanschluss ausgeführten zweiten Anschluss von außerhalb des Napfs kommend zum LED-Chip.

SMD-Leuchtdioden bestehen aus einem Leadframe mit wenigstens einer Bestückungsfläche für mindestens einen LED-Chip sowie elektrischen Anschlussflächen. Das Leadframe ist von einem Kunststoffkörper mit zumindest einer die wenigstens eine Bestückungsfläche freihaltenden Ausnehmung teilweise umspritzt. Die elektrischen Anschlussflächen des Leadframes sind hierbei als die elektrischen Anschlüsse der SMD-Leuchtdiode zur späteren Oberflächenmontage ebenfalls freigehalten. Der mindestens eine LED-Chip ist am Grund der zumindest einen zur wenigstens einen Bestückungsfläche reichenden Ausnehmung angeordnet und elektrisch kontaktiert. Dabei ist der LED-Chip auf einer mit wenigstens einer ersten elektrischen Anschlussfläche verbundenen ersten Partie des Leadframes angeordnet. Ein Bonddraht verbindet den LED-Chip mit einer zweiten Partie des Leadframes, die wiederum mit wenigstens einer zweiten elektrischen Anschlussfläche verbunden ist. Die an ihrem Grund zur Bestückungsfläche reichende Ausnehmung kann reflektorartig ausgestaltet sein. Dabei bilden die Wandungen der Ausnehmung den oben erwähnten Primärreflektor. Hierbei können die Wandungen reflektierend beschichtet sein.

COB-Leuchtdioden bestehen aus einem direkt auf einem Leuchtmittelträger anzuordnenden, ungehäusten LED-Chip und einem Bonddraht. Die Rückseite des LED-Chips bildet dabei den ersten elektrischen Anschluss der COB-Leuchtdiode. Zur elektrischen Kontaktierung wird der LED-Chip auf seiner Rückseite direkt mit einer ersten Leiterbahn eines Leuchtmittelträgers z.B. durch Löten oder Schweißen elektrisch verbunden. Der den zweiten elektrischen Anschluss der COB-Leuchtdiode bildende Bonddraht wird mit einer zweiten Leiterbahn des Leuchtmittelträgers ebenfalls z.B. durch Löten oder Schweißen elektrisch verbunden.

Der Vollständigkeit halber sei ergänzend erwähnt, dass auch andere Kontaktierungen wie z.B. der so genannte Flip-Chip-Aufbau möglich sind, bei dem die Kontaktmittel des LED-Chips direkt mit einem kontaktierten Substrat verbunden sind. In diesen Fällen wird kein Bonddraht verwendet.

Zusammengefasst weisen damit alle Leuchtdioden eine Montageseite auf, an der sich die elektrischen Anschlüsse befinden. Bei einer THT- oder SMD-Leuchtdiode ist dies diejenige Seite ihres die elektrischen Anschlüsse wenigstens teilweise umgebenden, beispielsweise durch die transparente Kapselung oder durch den Kunststoffkörper gebildeten, üblicherweise durch Spritzgießen hergestellten Schutzkörpers, aus der die elektrischen Anschlüsse wie bei der THT-Leuchtdiode ragen, oder an der die elektrischen Anschlussflächen des Leadframes freigehalten sind. Bei der COB-Leuchtdiode ist dies die der Lichtabstrahlrichtung abgewandte Rückseite des LED-Chips.

Zur Montage und elektrischen Kontaktierung von Leuchtdioden auf einem Leuchtmittelträger sind Montageflächen an einer oder mehreren Oberflächen des Leuchtmittelträgers ausgebildet. Im Falle von PCBs sind dies die parallel zu der durch das PCB aufgespannten Ebene liegenden Oberflächen des Leuchtmittelträgers. Im Falle eines in MID-Technik hergestellten spritzgegossenen Schaltungsträgers mit integrierter mechanischer und elektrischer bzw. elektronischer Funktion sind dies als Montageflächen ausgebildete Oberflächenpartien des Leuchtmittelträgers.

Die mindestens eine Montagefläche eines Leuchtmittelträgers ist dabei mit jeweils mindestens einer Leiterbahn des Leuchtmittelträgers elektrisch leitend verbundenen und mit den auf der Montageseite der Leuchtdiode angeordneten elektrischen Anschlüssen der Leuchtdiode korrespondierenden elektrischen Kontakten versehen. Die auf einer Montagefläche eines Leuchtmittelträges vorgesehenen elektrischen Kontakte können beispielsweise durch auf der Montagefläche verlaufende Leiterbahnen gebildet sein, oder durch auf einer der Montagefläche gegenüberliegenden Oberfläche des Leuchtmittelträgers verlaufende Leiterbahnen sowie die Montagefläche mit der gegenüberliegenden Oberfläche verbindende Löcher. In letzterem Fall umfassen die auf der Montageseite der Leuchtdiode oder eines Elektronikbauteils angeordneten elektrischen Anschlüsse Beinchen zur Durchsteckmontage.

Damit das Licht eines Leuchtmittels mit Leuchtdioden als Lichtquellen in einer gewünschten Richtung abgestrahlt wird, müssen entweder die Montageflächen der Leuchtmittelträger oder im Falle von PCBs die Leuchtmittelträger selbst oder die jeweilige Montageseite der Leuchtdioden in einer hierfür erforderlichen Richtung orientiert sein.

Allgemein bekannt sind so genannte planare Leuchtdioden, bei denen die Montageseite eine der Lichtabstrahlrichtung abgewandte Rückseite der Leuchtdiode bildet. Die Lichtabstrahlrichtung zeigt dabei in Richtung der Flächennormalen der Montageseite. Derartige Leuchtdioden werden stehend auf einem Leuchtmittelträger angeordnet.

Nachteilig an diesen Leuchtdioden ist, dass, wenn bei einem mit solchen Leuchtdioden als Lichtquellen ausgestatteten Leuchtmittel eine Lichtabstrahlung in verschiedenen Raumrichtungen verwirklicht werden muss, beispielsweise um bei Verwendung in einer Leuchte, wie etwa in einer Kraftfahrzeugleuchte, gesetzlichen Vorgaben für eine Lichtverteilung nachzukommen, welche mindestens einzuhaltende, umgangssprachlich als Helligkeit bezeichnete Lichtströme in zumindest einzuhaltenden Raumwinkelbereichen festlegt, der Leuchtmittelträger Montageflächen mit unterschiedlichen Lagen im Raum aufweisen muss. Sind PCBs als Leuchtmittelträger vorgesehen bedeutet dies die Notwendigkeit der Verwendung mehrerer in ihrer Lage im Raum unterschiedlich orientierter PCBs, um einer Lichtabstrahlung in den unterschiedlichen Raumrichtungen nachkommen zu können.

Durch EP 1 588 093 B1 und US 7,905,643 B2 sind als so genannte Sidelooker ausgebildete THT-Leuchtdioden bekannt, bei denen die Lichtabstrahlrichtung parallel zur Montageseite und damit parallel zur Montagefläche des Leuchtmittelträgers verläuft.

Durch DE 10 2006 051 542 B4 ist bekannt, bedrahtete THT-Leuchtdioden in einem Halter mit einer schräg zur Lichtabstrahlrichtung angeordneten Montageseite unterzubringen. Die Beinchen der THT-Leuchtdioden ragen an der Montageseite des Halters aus diesem heraus. Der Halter wird mitsamt den Leuchtdioden auf einem ebenen Leuchtmittelträger montiert. Die Montagefläche eines Leuchtmittelträgers muss zur Aufnahme der Beinchen mit korrespondierenden Löchern versehen sein. Der Leuchtmittelträger ist entweder auf seiner der Montageseite zugewandten Montagefläche, oder auf seiner dieser abgewandten Oberfläche mit den durch die Löcher gesteckten Beinchen der Leuchtdiode korrespondierenden elektrischen Kontakten versehen. Die Beinchen können zur Herstellung des elektrischen Kontakts mit den elektrischen Kontakten beispielsweise verlötet und/oder verschweißt sein.

Nachteilig an den zuvor beschriebenen Lösungen für THT-Leuchtdioden ist, dass lichtstarke LEDs derzeit nicht als THT-LEDs erhältlich sind. Da diese jedoch zunehmend in der Automobilindustrie gefordert sind und benötigt werden kommen lichtstärkere SMD LEDs zum Einsatz.

Durch DE 203 14 966 U1 und durch US 2008/0290439 A1 sind als Sidelooker ausgebildete SMD-Leuchtdioden mit abgeschrägter Montageseite bekannt, die auf einem PCB-Leuchtmittelträger in unterschiedlichen Montagewinkeln montiert werden können und dadurch eine Abstrahlung unter einem Winkel schräg zur Oberfläche des PCB-Leuchtmittelträgers ermöglichen.

Nachteilig an diesen Sidelooker SMD-Leuchtdioden ist ,dass diese aufgrund ihrer schlechten Wärmeableitung ineffizient sind und eine hohe hermische Degradation aufweisen.

Die Nachteile des Standes der Technik könnten durch Verwendung von als Kunststoffspritzteil in MID Technik hergestellter, spritzgegossener Schaltungsträger mit in das Kunststoffspritzteil integrierten Leiterbahnen und integrierter mechanischer und elektrischer bzw. elektronischer Funktion ausgebildeter Leuchtmittelträger mit mehrdimensional und multidirektional ausgerichteten Montageflächen teilweise beseitigt werden, wären in MID-Technik hergestellte Schaltungsträger nicht sehr kostspielig in der Herstellung und insbesondere bei einer mehrdimensionalen und multidirektionalen Ausrichtung der Montageflächen sehr kompliziert beim Umgang und der Bestückung mit den als Lichtquellen vorgesehenen Leuchtdioden.

Zusammengefasst sind damit in allen Fällen Leuchtmittelträger bestehend aus mehreren PCBs bzw. Platinen notwendig, einhergehend mit einem hohen Montageaufwand.

Eine Kombination eines Leuchtmittelträgers mit den bekannten Leuchtdioden hat darüber hinaus einen hohen Herstellungsaufwand für die verschieden ausgestalteten Leuchtdioden zur Folge und ist mit einer aufwändigen Lagerhaltung für die verschieden ausgestalteten Leuchtdioden verbunden. Auch muss das Binning für alle unterschiedlichen Montagewinkel separat durchgeführt werden. Darüber hinaus ergibt sich die Gefahr der Fehlmontage einer Sorte von Leuchtdioden auf für eine andere Sorte von Leuchtdioden vorgesehenen Montageflächen.

Ein Ziel bei der Entwicklung von in Großserie hergestellter Leuchtmittel ist die Verringerung der Kosten. Dies kann erreicht werden beispielsweise durch:
- Einsparungen bei der Anzahl der benötigten Einzelteile, wodurch der Montageaufwand und dadurch die benötigte Zeit zur Montage verringert werden können, einhergehend mit verringerten Montagekosten,
- Einsparungen bei der Anzahl der verschiedenartigen Einzelteile, wodurch es zu weniger Fehlmontagen kommt und der Ausschuss verringert werden kann, was die Gesamtkosten senkt, und darüber hinaus eine vereinfachte Lagerlogistik einhergehend mit verringerten Lagerhaltungskosten erreicht werden,
- Einsparungen bei der Anzahl von unterschiedlichen Lichtquellen, wodurch Bestückung, Montage und Umgang vereinfacht und dadurch Bestückungs-, Montage- und durch die Verringerung von Ausschuss die Herstellungskosten verringert werden können.

Leuchtdioden mit unter einer Vielzahl verschiedener Montagewinkel angeordneten Montageseiten stehen diesem Ziel entgegen.

Eine Aufgabe der Erfindung ist es deshalb, einen Halter zur elektrischen Kontaktierung und mechanischen Befestigung mindestens einer SMD-Leuchtdiode zu entwickeln, welches die Herstellung gleichartiger oder verschiedenartiger Leuchtmittel mit einer oder mehreren Leuchtdioden als Lichtquellen unter Einhaltung der benannten Einsparungen ermöglicht.

Die Erfindung wird gelöst mit den Merkmalen des unabhängigen Anspruchs.

Demnach ist zur Lösung der Aufgabe ein nachfolgend auch als Sidelooker-Halter bezeichneter Halter für wenigstens eine SMD-Leuchtdiode vorgesehen. Der Halter weist wenigstens zwei unter einem Winkel zueinander angeordnete, nicht parallele Montageflächen auf, zumindest eine erste Montagefläche für die mindestens eine SMD-Leuchtdiode und zumindest eine zweite Montagefläche zur Montage des Halters auf einem Leuchtmittelträger.

Zumindest die mindestens eine erste Montagefläche für die mindestens eine SMD-Leuchtdiode weist in einer durch die jeweilige Montagefläche gebildeten Ebene liegende elektrische Anschlüsse auf, welche bei der Montage einer SMD-Leuchtdiode auf der Montagefläche die SMD-Leuchtdiode elektrisch kontaktieren.

Zumindest die mindestens eine zweite Montagefläche zur Montage des Halters auf einem Leuchtmittelträger weist ebenfalls elektrische Anschlüsse auf, welche bei der Montage des Halters auf einem Leuchtmittelträger elektrische Verbindungen zu elektrischen Leiterbahnen des Leuchtmittelträgers herstellen.

Die elektrischen Anschlüsse der ersten und der zweiten Montageflächen des Halters sind derart elektrisch miteinander verbunden, dass bei auf dem Halter montierter SMD-Leuchtdiode und auf dem Leuchtmittelträger montiertem Halter eine an den elektrischen Leiterbahnen des Leuchtmittelträgers anliegende Spannung einen eine Lichtemission der SMD-Leuchtdiode bewirkenden Stromfluss via der elektrischen Anschlüsse durch die SMD-Leuchtdiode zur Folge hat.

Die zumindest eine zweite Montagefläche zur Montage des Halters auf einem Leuchtmittelträger kann ebenfalls als SMD-Montagefläche ausgebildet sein, welche in einer durch die jeweilige Montagefläche gebildeten Ebene liegende elektrische Anschlüsse aufweist, welche bei der Montage des Halters auf einem Leuchtmittelträger elektrische Verbindungen zu mit elektrischen Leiterbahnen des Leuchtmittelträgers elektrisch verbundenen, entsprechenden elektrischen Anschlussflächen des Leuchtmittelträgers herstellen.

Alternativ kann die zumindest eine zweite Montagefläche zur Montage des Halters auf einem Leuchtmittelträger als THT-Montagefläche ausgebildet sein, welche auf der jeweiligen Montagefläche bzw. auf einer durch die jeweilige Montagefläche gebildeten Ebene aufstehende elektrische Anschlüsse aufweist, welche bei der Montage des Halters auf einem Leuchtmittelträger in von elektrischen Leiterbahnen des Leuchtmittelträgers zumindest zum Teil umgebene Ausnehmungen im Leuchtmittelträger eingreifen, um elektrische Verbindungen mit diesen herzustellen.

Zumindest eine erste Montagefläche für die mindestens eine SMD-Leuchtdiode des Halters kann unter einem Winkel von 90° zu wenigstens einer zweiten Montagefläche zur Montage des Halters auf einem Leuchtmittelträger angeordnet sein.

Zumindest eine erste Montagefläche für die mindestens eine SMD-Leuchtdiode des Halters kann unter einem Winkel von 0°zu wenigstens einer zweiten Montagefläche zur Montage des Halters auf einem Leuchtmittelträger angeordnet sein.

Zumindest eine erste Montagefläche für die mindestens eine SMD-Leuchtdiode des Halters kann unter einem Winkel größer 0° und kleiner als 90° zu wenigstens einer zweiten Montagefläche zur Montage des Halters auf einem Leuchtmittelträger angeordnet sein vorzugsweise unter einem Winkel von 30° und/oder 60°. Die Angabe einer Anordnung unter einem Winkel von 30° und 60° bezieht sich dabei auf mehrere erste Montageflächen für jeweils mindestens eine SMD-Leuchtdiode in Bezug auf eine oder verschiedene zweite Montageflächen.

Bezugnehmend auf eine normal auf einer zweiten Montagefläche aufstehende Achse können verschiedene erste Montageflächen beispielsweise Winkel von 0°, 30°, 45°, 60°, 90°einschließen.

Die ersten Montageflächen können bezüglich einer normal auf einer zweiten Montagefläche aufstehenden Achse auf der selben Seite angeordnet sein, oder es können verschiedene erste Montageflächen in verschiedenen Winkeln beispielsweise gleichmäßig um diese Achse herum verteilt angeordnet sein.

Jede Montagefläche kann mit eigenen elektrischen Anschlüssen versehen sein. Alternativ können gemeinsame elektrische Anschlüsse vorgesehen sein, die sich beispielsweise über mehrere, beispielsweise alle Montageflächen erstrecken.

Der Halter kann einen unter Freilassung an den Montageflächen die elektrischen Anschlüsse zumindest teilweise umgebenden, vorzugsweise durch Spritzgießen aus Kunststoff hergestellten Schutzkörper umfassen.

Die Montageflächen können durch die Form des Schutzkörpers definiert und hergestellt sein. Der Schutzkörper bildet dabei ein Gehäuse des Halters, welcher aufgrund seiner Gehäuseform mehrere Montageflächen mit gemeinsamen oder jeweils eigenen elektrischen Anschlüssen aufweist.

Der Halter kann eine Ausnehmung in mindestens einer zweiten Montagefläche aufweisen. Der Halter kann demnach massiv, oder mit einer beispielsweise spaltförmigen Ausnehmung auf seiner in montiertem Zustand einem Leuchtmittelträger zugewandten Seite ausgeführt sein.

Ein mit einer Ausnehmung in mindestens einer zweiten Montagefläche ausgeführter Halter kann in Form eines Bügels ausgeführt sein.

Es ist ersichtlich, dass die Erfindung verwirklicht sein kann durch einen Sidelooker-Halter, der eine erste Montagefläche mit elektrischen Anschlüssen für hierauf unter elektrischer Kontaktierung anordbare SMD-Leuchtdioden aufweist. Die erste Montagefläche ist unter einem vorgegebenen Neigungswinkel gegenüber einer zur Kontaktierung mit einer Platine odgl. vorgesehenen, als Grundfläche des Halters dienenden zweiten Montagefläche geneigt. Es können unterschiedliche Neigungswinkel von beispielsweise 30°, 45°, 60°, 90°verwirklicht sein. Der Halter kann im SMD-Verfahren bestückt werden und selbst mit oder ohne SMD-LED versehen im SMD-Verfahren auf Leuchtmittelträger, wie beispielsweise Platinen odgl. bestückt werden.

Vorteile gegenüber dem Stand der Technik ergeben sich durch die Möglichkeit, kostengünstig verfügbare Leuchtdioden vermittels des Halters universell einzusetzen. Hierdurch können Montage-, Gesamt- und Lagerhaltungskosten bei der Herstellung von Leuchtmitteln mit SMD-Leuchtdioden als Lichtquellen verringert werden.

Zusätzliche Vorteile ergeben sich dadurch, dass der Sidelooker-Halter für sämtliche auf dem Markt vorhandene LEDs ausgestaltet werden kann. Hierdurch ergibt sich eine hohe Einsatz-Flexibilität, unter Anderem auch für die Auswahl der Abstrahlcharakteristik, Leistung, Wellenlänge und Vorwärtsspannung der Leuchtdioden. Der Sidelooker-Halter selbst ist wiederum SMD lötbar und als Bauteil auf einer Rolle erhältlich. Dies erlaubt eine standard Verarbeitung für SMD Bestücker. Hierdurch wird eine einfache Verwendbakeit in bestehenden, automatisierten Prozessen ermöglicht.

Weitere Vorteile ergeben sich durch eine Einsparung von Platinenmaterial und/oder Steckern zur Verbindung mehrerer Platinen, eine hohe optische Effizienz, da der Winkelversatz zur Platinenoberfläche nicht mittels einer Optik, sondern mittels eines mechanischen Teils erzielt wird, höhere erzielbare Helligkeiten.

Der Sidelooker-Halter erlaubt darüber hinaus eine thermisch optimierte Anbindung von SMD Leuchtdioden an einen Leuchtmittelträger unter zu dessen Oberfläche geneigter Abstrahlrichtung von beispielsweise 90°. Eine beim Stand der Technik bestehende Begrenzung einer maximalen Bestromung ist dadurch aufhebbar, da die thermische Ableitung des Sidelooker-Halters sehr effizient ist.

Die Erfindung wird nachfolgend anhand von in den Zeichnungen dargestellter Ausführungsbeispiele näher erläutert. Darin bezeichnen gleiche Bezugszeichen gleiche oder gleich wirkende Elemente. Der Übersicht halber sind nur Bezugszeichen in den einzelnen Zeichnungen dargestellt, die für die Beschreibung der jeweiligen Zeichnung erforderlich sind. Die Größenverhältnisse der einzelnen Elemente zueinander entsprechen dabei nicht immer den realen Größenverhältnissen, da einige Formen vereinfacht und andere Formen zur besseren Veranschaulichung vergrößert im Verhältnis zu anderen Elementen dargestellt sind. Es zeigen in schematischer Darstellung:
- Fig. 1: ein erstes Ausführungsbeispiel eines Halters zur elektrischen Kontaktierung und mechanischen Befestigung einer SMD-Leuchtdiode in perspektivischer Ansicht.
- Fig. 2: eine perspektivische Ansicht des Halters aus Fig. 1 von unten.
- Fig. 3: eine erste Montageposition des Halters aus Fig. 1 mit auf einer Montagefläche montierter SMD-Leuchtdiode in einer perspektivischen Ansicht.
- Fig. 4: eine zweite Montageposition des Halters aus Fig. 1 mit auf einer Montagefläche montierter SMD-Leuchtdiode in einer Seitenansicht.
- Fig. 5: den Halter aus Fig. 1 mit auf einer Montagefläche montierter SMD-Leuchtdiode in einer Seitenansicht.
- Fig. 6: ein zweites Ausführungsbeispiel eines Halters zur elektrischen Kontaktierung und mechanischen Befestigung einer SMD-Leuchtdiode in perspektivischer Ansicht.
- Fig. 7: den Halter aus Fig. 6 mit auf einer Montagefläche montierter SMD-Leuchtdiode in einer perspektivischen Ansicht.

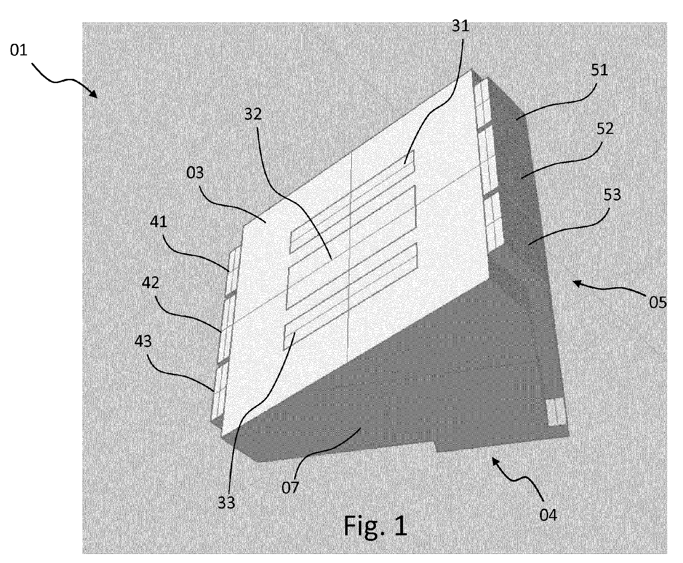

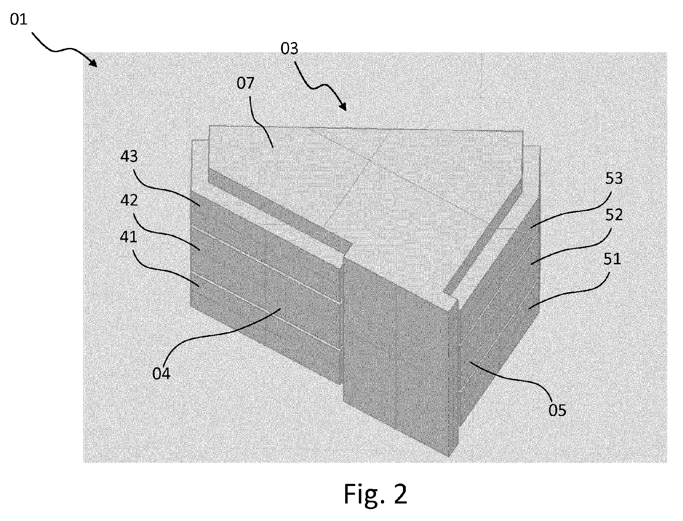

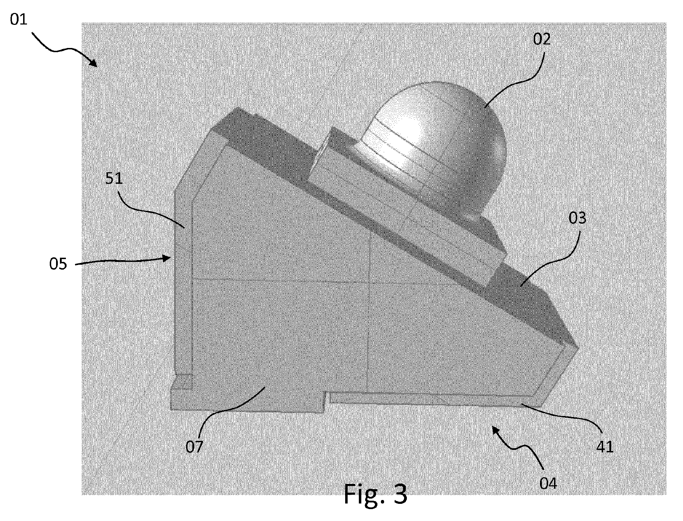

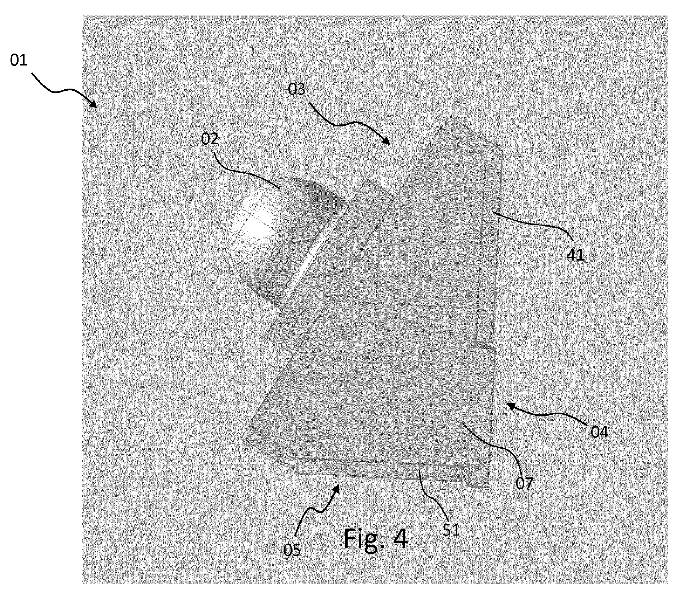

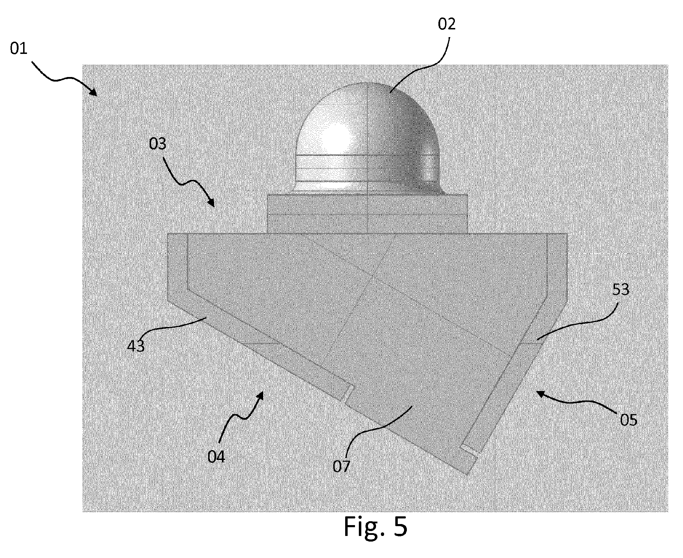

Ein in den Fig. 1 bis Fig. 7 ganz oder in Teilen dargestellter Halter 01 zur elektrischen Kontaktierung und mechanischen Befestigung mindestens einer SMD-Leuchtdiode 02 umfasst wenigstens zwei unter einem Winkel zueinander angeordnete, nicht parallele Montageflächen 03, 04, 05. Bei diesen Montageflächen 03, 04, 05 handelt es sich um mindestens eine erste Montagefläche 03 für die mindestens eine SMD-Leuchtdiode 02 und um mindestens eine zweite Montagefläche 04, 05 zur Montage des Halters 01 auf einem Leuchtmittelträger.

Die mindestens eine erste Montagefläche 03 für die mindestens eine SMD-Leuchtdiode 02 weist in einer durch die jeweilige Montagefläche gebildeten Ebene liegende elektrische Anschlüsse 31, 32, 33 auf, welche bei der Montage einer SMD-Leuchtdiode 02 auf der ersten Montagefläche 03 die SMD-Leuchtdiode 02 elektrisch kontaktieren.

Die mindestens eine zweite Montagefläche 04, 05 zur Montage des Halters 01 auf einem Leuchtmittelträger weist ebenfalls elektrische Anschlüsse 41, 42, 43, 51, 52, 53 auf, welche bei der Montage des Halters 01 auf einem Leuchtmittelträger elektrische Leiterbahnen des Leuchtmittelträgers elektrisch kontaktieren bzw. elektrische Verbindungen zu elektrischen Leiterbahnen des Leuchtmittelträgers herstellen. Die elektrischen Anschlüsse 31, 32, 33, 41, 42, 43, 51, 52, 53 der ersten und der zweiten Montageflächen 03, 04, 05 des Halters 01 sind derart elektrisch miteinander verbunden, dass an den elektrischen Anschlüssen 31, 32, 33 der mindestens einen ersten Montagefläche 03 eine an den elektrischen Anschlüssen 41, 42, 43, 51, 52, 53 der mindestens einen zweiten Montagefläche 04, 05 anliegende elektrische Spannung anliegt bzw. eine einer an den elektrischen Anschlüssen 41, 42, 43, 51, 52, 53 der mindestens einen zweiten Montagefläche 04, 05 angelegten elektrischen Spannung proportionale, vorzugsweise im Wesentlichen identische elektrische Spannung anliegt, so dass bei auf dem Halter 01 montierter SMD-Leuchtdiode 02 und auf dem Leuchtmittelträger montiertem Halter 01 eine an den elektrischen Leiterbahnen des Leuchtmittelträgers anliegende Spannung einen eine Lichtemission der SMD-Leuchtdiode 02 bewirkenden Stromfluss via der elektrischen Anschlüsse 31, 32, 33, 41, 42, 43, 51, 52, 53 durch die SMD-Leuchtdiode 02 zur Folge hat.

Die zumindest eine zweite Montagefläche 04, 05 zur Montage des Halters 01 auf einem Leuchtmittelträger kann wie die mindestens eine erste Montagefläche 03 für die mindestens eine SMD-Leuchtdiode 02 ebenfalls als SMD-Montagefläche ausgebildet sein. In diesem Fall kann die mindeistens eine zweite Montagefläche 04, 05 in einer durch die jeweilige Montagefläche 04, 05 gebildeten Ebene liegende elektrische Anschlüsse 41, 42, 43, 51, 52, 53 aufweisen, die bei der Montage des Halters 01 auf einem Leuchtmittelträger elektrische Verbindungen zu mit elektrischen Leiterbahnen des Leuchtmittelträgers elektrisch verbundenen, entsprechenden elektrischen

Anschlussflächen des Leuchtmittelträgers herstellen.

Sich hierdurch ergebende Vorteile sind neben einer einfachen automatisierten Bestückung des Halters 01 auf einem Leuchtmittelträger die Möglichkeit, den Halter 01 wie in Fig. 1 bis Fig. 5 dargestellt derart auszubilden, dass jede Montagefläche 03, 04, 05 gleichermaßen als erste oder zweite Montagefläche 03, 04, 05 geeignet ist.

Die zumindest eine zweite Montagefläche 04, 05 zur Montage des Halters 01 auf einem Leuchtmittelträger kann alternativ als THT-Montagefläche ausgebildet ist, welche auf der jeweiligen Montagefläche 04, 05 bzw. auf einer durch die jeweilige Montagefläche 04, 05 gebildeten Ebene aufstehende elektrische Anschlüsse 41, 42, 43, 51, 52, 53 aufweist, die bei der Montage des Halters 01 auf einem Leuchtmittelträger in von elektrischen Leiterbahnen des Leuchtmittelträgers zumindest zum Teil umgebene Ausnehmungen im Leuchtmittelträger eingreifen, um elektrische Verbindungen mit diesen herzustellen.

Zumindest eine erste Montagefläche 03 für die mindestens eine SMD-Leuchtdiode 02 des Halters 01 kann unter einem Winkel von 90° zu wenigstens einer zweiten Montagefläche 04, 05 zur Montage des Halters 01 auf einem Leuchtmittelträger angeordnet sein. Beispielsweise liegt zwischen den Montageflächen 04, 05 des Halters 01 in Fig. 1 bis Fig. 6 ein Winkel von 90°.

Zumindest eine erste Montagefläche 03 des Halters für die mindestens eine SMD-Leuchtdiode 01 kann unter einem Winkel von 0° zu wenigstens einer zweiten Montagefläche 04, 05 zur Montage des Halters auf einem Leuchtmittelträger angeordnet sein. Hierbei liegen die erste Montagefläche 03 und eine zweite Montagefläche 04, 05 bzw. die durch diese gebildeten oder diese einschließenden Ebenen parallel zueinander.

Zumindest eine erste Montagefläche 03 des Halters 01 für die mindestens eine SMD-Leuchtdiode 02 kann unter einem Winkel größer 0° und kleiner als 90° zu wenigstens einer zweiten Montagefläche 04, 05 zur Montage des Halters 01 auf einem Leuchtmittelträger angeordnet sein, vorzugsweise unter einem Winkel von 30° und/oder 45° und/oder 60°. Beispielsweise ist die erste Montagefläche 03 eines in Fig. 1 bis Fig. 7 dargestellten Halters 01 unter einem Winkel von 30° zur zweiten Montagefläche 04 angeordnet. Beispielsweise ist die erste Montagefläche 03 des in Fig. 1 bis Fig. 5 dargestellten Halters 01 unter einem Winkel von 60° zur zweiten Montagefläche 05 angeordnet. Demnach kann ein Halter 01 eine oder mehrere unter unterschiedlichen Winkeln zu einer oder mehreren zweiten Montageflächen 04, 05 angeordnete erste Montageflächen 03 aufweisen.

Beispielsweise können verschiedene erste Montageflächen 03 bezugnehmend auf eine normal auf einer zweiten Montagefläche 04, 05 bzw. auf einer durch eine zweite Montagefläche 04, 05 gebildeten Ebene aufstehende Achse Winkel von 0° und/oder 30° und/oder 45° und/oder 60° und/oder 90° einschließen.

Mehrere erste Montageflächen 03 können bezüglich einer normal auf einer zweiten Montagefläche 04, 05 bzw. auf einer durch eine zweite Montagefläche 04, 05 gebildeten Ebene aufstehenden Achse auf der selben Seite angeordnet sein.

Alternativ oder zusätzlich können mehrere zweite Montageflächen 04, 05 können bezüglich einer normal auf einer ersten Montagefläche 03 bzw. auf einer durch eine erste Montagefläche 03 gebildeten Ebene aufstehenden Achse auf der selben Seite angeordnet sein.

Alternativ oder zusätzlich können mehrere erste Montageflächen 03 bezüglich einer normal auf einer zweiten Montagefläche 04, 05 bzw. auf einer durch eine zweite Montagefläche 04, 05 gebildeten Ebene aufstehenden Achse in verschiedenen Winkeln um diese Achse herum beispielsweise gleichmäßig verteilt angeordnet sein.

Alternativ oder zusätzlich können mehrere zweite Montageflächen 04, 05 bezüglich einer normal auf einer ersten Montagefläche 03 bzw. auf einer durch eine erste Montagefläche 03 gebildeten Ebene aufstehenden Achse in verschiedenen Winkeln um diese Achse herum beispielsweise gleichmäßig verteilt angeordnet sein.

Jede Montagefläche 04, 05, 06 kann mit eigenen elektrischen Anschlüssen 31, 32, 33, 41, 42, 43, 51, 52, 53 versehen sein.

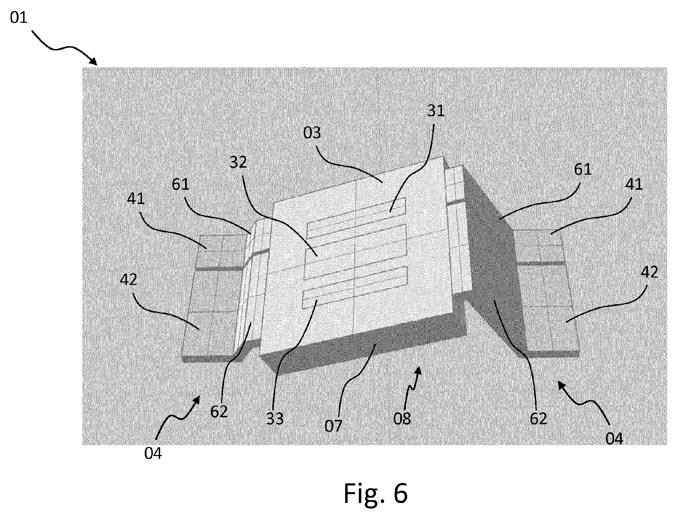

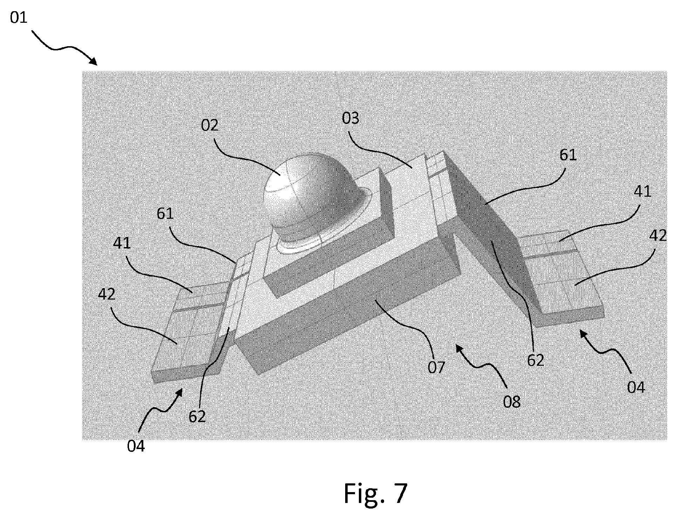

Alternativ können wie in Fig. 6 und Fig. 7 ersichtlich durch gemeinsame elektrische Leiter 61, 62 gebildete elektrische Anschlüsse 31, 32, 33, 41, 42 vorgesehen sein, welche elektrische Leiter 61, 62 sich beispielsweise über mehrere, beispielsweise alle Montageflächen 03, 04 erstrecken.

Der Halter 01 kann einen vorzugsweise durch Spritzgießen aus Kunststoff hergestellten Schutzkörper 07 umfassen. Der Schutzkörper umgibt unter Freilassung zumindest der elektrischen Anschlüsse 31, 32, 33, 41, 42, 43, 51, 52, 53 wenigstens an den Montageflächen 03, 04, 05 die elektrischen Anschlüsse 31, 32, 33, 41, 42, 43, 51, 52, 53 bildende und/oder auf vorgegebene Weise elektrisch miteinander verbindende elektrische Leiter zumindest teilweise.

Die Montageflächen 03, 04, 05 können durch die Form des Schutzkörpers 07 definiert und hergestellt sein. Der Schutzkörper 07 bildet dabei ein Gehäuse des Halters 01, welcher aufgrund seiner Gehäuseform mehrere Montageflächen 03, 04, 05 mit gemeinsamen oder jeweils eigenen elektrischen Anschlüssen 31, 32, 33, 41, 42, 43, 51, 52, 53 aufweist.

Der Halter 01 kann wie in Fig. 6 und Fig. 7 dargestellt eine Ausnehmung 08 in mindestens einer zweiten Montagefläche 04 aufweisen.

Der Halter 01 kann demnach wie in Fig. 1 bis Fig. 5 dargestellt massiv, oder wie in Fig. 6 und Fig. 7 dargestellt mit einer beispielsweise spaltförmigen Ausnehmung 08 auf seiner in montiertem Zustand einem Leuchtmittelträger zugewandten Seite ausgeführt sein.

Ein mit einer Ausnehmung 08 in mindestens einer zweiten Montagefläche 04 ausgeführter Halter 01 kann in Form eines Bügels ausgeführt sein.

Die Erfindung ist insbesondere im Bereich der Herstellung von Leuchtmitteln mit SMD-Leuchtdioden als Lichtquellen für Beleuchtungszwecke gewerblich anwendbar.

Die Erfindung wurde unter Bezugnahme auf eine bevorzugte Ausführungsform beschrieben. Es ist jedoch für einen Fachmann vorstellbar, dass Abwandlungen oder Änderungen der Erfindung gemacht werden können, ohne dabei den Schutzbereich der nachstehenden Ansprüche zu verlassen.

### Bezugszeichenliste

- 01: Halter
- 02: SMD-Leuchtdiode
- 03: Montagefläche
- 04: Montagefläche
- 05: Montagefläche
- 07: Schutzkörper
- 08: Ausnehmung
- 31: elektrischer Anschluss
- 32: elektrischer Anschluss
- 33: elektrischer Anschluss
- 41: elektrischer Anschluss
- 42: elektrischer Anschluss
- 43: elektrischer Anschluss
- 51: elektrischer Anschluss
- 52: elektrischer Anschluss
- 53: elektrischer Anschluss
- 61: elektrischer Leiter
- 62: elektrischer Leiter

## Patentansprüche

1. Halter (01) zur elektrischen Kontaktierung und mechanischen Befestigung mindestens einer SMD-Leuchtdiode (02) mit wenigstens zwei unter einem Winkel zueinander angeordneten Montageflächen (03, 04, 05), zumindest einer ersten Montagefläche für die mindestens eine SMD-Leuchtdiode (02) und zumindest einer zweiten Montagefläche (04, 05) zur Montage des Halters (01) auf einem Leuchtmittelträger, wobei die mindestens eine erste Montagefläche (03) in einer durch die jeweilige erste Montagefläche (03) gebildeten Ebene liegende elektrische Anschlüsse (31, 32, 33) aufweist, welche bei der Montage einer SMD-Leuchtdiode (02) auf der ersten Montagefläche die SMD-Leuchtdiode (02) elektrisch kontaktieren, und die mindestens eine zweite Montagefläche (04, 05) ebenfalls elektrische Anschlüsse (41, 42, 43, 51, 52, 53) aufweist, welche bei der Montage des Halters (01) auf einem Leuchtmittelträger elektrische Leiterbahnen des Leuchtmittelträgers elektrisch kontaktieren, wobei die elektrischen Anschlüsse (31, 32, 33, 41, 42, 43, 51, 52, 53) der ersten und der zweiten Montageflächen (04, 05) des Halters (01) derart elektrisch miteinander verbunden sind, dass an den elektrischen Anschlüssen (31, 32, 33) der mindestens einen ersten Montagefläche (03) eine elektrische Spannung anliegt, wenn an den elektrischen Anschlüssen (41, 42, 43, 51, 52, 53) der mindestens einen zweiten Montagefläche (04, 05) eine elektrische Spannung angelegt ist.

2. Halter nach Anspruch 1, wobei die zumindest eine zweite Montagefläche (04, 05) ebenfalls als SMD-Montagefläche ausgebildet ist, welche in einer durch die jeweilige zweite Montagefläche (04, 05) gebildeten Ebene liegende elektrische Anschlüsse (41, 42, 43, 51, 52, 53) aufweist, die bei der Montage des Halters (01) auf einem Leuchtmittelträger elektrische Verbindungen zu mit elektrischen Leiterbahnen des Leuchtmittelträgers elektrisch verbundenen, entsprechenden elektrischen Anschlussflächen des Leuchtmittelträgers herstellen.

3. Halter nach Anspruch 1, wobei die zumindest eine zweite Montagefläche (04, 05) als THT-Montagefläche ausgebildet ist, welche auf einer durch die jeweilige zweite Montagefläche (04, 05) gebildeten Ebene aufstehende elektrische Anschlüsse (41, 42, 43, 51, 52, 53) aufweist, die bei der Montage des Halters (01) auf einem Leuchtmittelträger in von elektrischen Leiterbahnen des Leuchtmittelträgers zumindest zum Teil umgebene Ausnehmungen im Leuchtmittelträger eingreifen, um elektrische Verbindungen mit diesen herzustellen.

4. Halter nach Anspruch 1, 2 oder 3, wobei zumindest eine erste Montagefläche (03) des Halters (01) unter einem Winkel von 90° zu wenigstens einer zweiten Montagefläche (04, 05) angeordnet ist.

5. Halter nach einem der voranstehenden Ansprüche, wobei zumindest eine erste Montagefläche (03) des Halters (01) unter einem Winkel von 0° zu wenigstens einer zweiten Montagefläche (04, 05) angeordnet ist.

6. Halter nach einem der voranstehenden Ansprüche, wobei zumindest eine erste Montagefläche (03) des Halters (01) unter einem Winkel größer 0° und kleiner als 90° zu wenigstens einer zweiten Montagefläche (04, 05) angeordnet ist.

7. Halter nach einem der voranstehenden Ansprüche, wobei verschiedene erste Montageflächen (03) bezugnehmend auf eine normal auf einer durch eine zweite Montagefläche (04, 05) gebildeten Ebene aufstehende Achse Winkel von 0° und/oder 30° und/oder 45° und/oder 60° und/oder 90° einschließen.

8. Halter nach einem der voranstehenden Ansprüche, wobei mehrere erste Montageflächen (03) bezüglich einer normal auf einer durch eine zweite Montagefläche (04, 05) gebildeten Ebene aufstehenden Achse auf der selben Seite angeordnet sind.

9. Halter nach einem der voranstehenden Ansprüche, wobei mehrere erste Montageflächen (03) bezüglich einer normal auf einer durch eine zweite Montagefläche (04, 05) gebildeten Ebene aufstehenden Achse in verschiedenen Winkeln um diese Achse herum verteilt angeordnet sind.

10. Halter nach Anspruch 9, wobei mehrere erste Montageflächen (03) gleichmäßig um die normal auf einer durch eine zweite Montagefläche (04, 05) gebildeten Ebene aufstehende Achse herum verteilt angeordnet sind.

11. Halter nach einem der voranstehenden Ansprüche, wobei jede Montagefläche mit eigenen elektrischen Anschlüssen (31, 32, 33, 41, 42, 43, 51, 52, 53) versehen ist.

12. Halter nach einem der Ansprüche 1 bis 10, wobei gemeinsame elektrische Anschlüsse (31, 32, 33, 41, 42, 43, 51, 52, 53, 61, 62) vorgesehen sind, die sich beispielsweise über mehrere Montageflächen (03, 04, 05) erstrecken.

13. Halter nach einem der voranstehenden Ansprüche, wobei der Halter (01) einen unter Freilassung zumindest an den Montageflächen (03, 04, 05) die elektrischen Anschlüsse zumindest teilweise umgebenden Schutzkörper (07) umfasst.

14. Halter nach einem der voranstehenden Ansprüche, wobei die Montageflächen (03, 04, 05) durch die Form des Schutzkörpers (07) definiert und hergestellt sind.

15. Halter nach einem der voranstehenden Ansprüche, wobei der Halter (01) eine Ausnehmung (08) in mindestens einer zweiten Montagefläche (04, 05) aufweist.
